# EUROPEAN PATENT SPECIFICATION

(11) **EP 1 789 988 B1**
(45) Date of publication and mention of the grant of the patent: **15.09.2010**
(21) Application number: 04766233.3
(22) Date of filing: 15.07.2004
(51) Int. Cl.: H01J 49/16, B01L 3/00

(54) **LIQUID TRANSPORTATION AND CRYSTALLIZATION GROWTH**
FLÜSSIGKEITSTRANSPORT UND KRISTALLISIERUNGSWACHSTUM
TRANSPORT DE LIQUIDES ET CROISSANCE CRISTALLINE

(43) Date of publication of application: 30.05.2007
(73) Proprietor: Agilent Technologies, Inc., Santa Clara CA 95051 (US)
(72) Inventor: DEHMER, Bernhard, 76437 Rastatt (DE)
(74) Representative: Barth, Daniel Mathias
(86) International application number: PCT/EP2004/051505
(87) International publication number: WO 2006/005376

(56) References cited:
- EP-A- 1 205 247
- WO-A-03/004159
- US-A- 5 882 930
- US-A1- 2003 039 585
- US-A1- 2003 099 577
- US-A1- 2003 124 599

## Description

### BACKGROUND ART

The invention refers to transporting liquids and to crystal growth.

In chemical identification, mass spectroscopy is a well-established analytical method. Using "soft ionization" techniques like MALDI-MS (matrix-assisted laser desorption/ionization mass spectrometry) even large biomolecules and synthetic polymers are suitable for this analysis method.

Often the specimen to be analyzed is liquid. In another example the specimen is solid but has to be dissolved in a solvent for various reasons. With, for example MALDI-MS the analyte and a matrix are mixed first at a molecular level in an appropriate solvent and then co-crystallized on a suitable carrier plate for being analyzed within the MALDI instrument. The crystallization is performed by evaporation of the solvent. The remaining analyte is included in a crystal structure formed by the matrix on the surface of the carrier plate. When using only small volumes of liquids huge numbers of samples can be processed simultaneously.

However the quality of sample preparation for further processing or later analysis of the specimen is of importance in relation to the quality of the analysis results.

Various approaches to improve for example MALDI preparation like sample concentration and localization on the carrier plate, crystal grow, crystal distribution, crystal structure and crystal purity have been made. A further example can be found in DE 199 49 735, wherein a carrier comprises a not easily wettable or lyophobic carrier surface with an easily wettable or lyophilic anchor. The sample solution is arranged on that anchor. The evaporation process of a solvent and the well-defined lyophilic anchor in the lyophobic carrier surface leads to a well-defined structured crystal growth of the specimen on the area of the lyophilic anchor.
[0005a] US 2003/0124599 A1 discloses a biochemical analysis system with combinatorial chemistry applications. Figs. 17 show a through-hole tapered with a smaller end at the inserting exit. The capillary force near the exit is larger than at the opposite end. In this way, the liquid is drawn towards the narrowed exit portion of the through-hole. A controlled evaporation can be induced to reduce the solvent volume in the through-hole and concentrating the molecules.

### DISCLOSURE

It is an object of the invention to improve liquid transportation. The object is solved by the independent claims. Preferred embodiments are subject of the dependant claims.

A matrix-assisted laser desorption/ionization mass spectrometry - MALDI-MS - comprises a device for transporting liquid and supporting crystal growth and which represents a MALDI target. The device comprises a hollow space in a body having a surface. The hollow space has a first orifice connected to the surface and is adapted for generating a directed capillary effect towards the first orifice in order to transport liquid to the first orifice and to support crystal growth on the surface, A laser source provides a laser beam onto the MALDI target.

In an embodiment of the invention the hollow space might be adapted as a vessel. The hollow space or the vessel is adapted for receiving liquid. Additionally the structure of the hollow space is adapted for generating the directed capillary effect. The directed capillary effect forces the liquid to flow along a specific direction. Thus, embodiments of the invention allow transporting liquid, preferably to a specific place. The device might also be a vessel, the vessel comprising an aperture and being adapted for generating the directed capillary effect. The flow of liquid within the hollow space along the direction given by directed capillary effect allows a concentration of the liquid in a well-defined area. Hence a liquid can be transported to a specific area and forced to remain there.

In embodiments of the invention, the directed capillary effect can be used to provide a mixing or reaction area and - in another embodiment - a microlab reaction chamber. In such embodiment the capillary effect is directed towards the mixing or reaction area, also being formed within the body respectively. The different solvent and the reactants are transported in the liquid to the mixing area or the reaction chamber. In exemplary embodiments the reaction chamber is connected to a plurality of vessels, some of them being adapted for generating a directed capillary effect towards the chamber.

The invention provides an improved crystal growth. The orifice is adapted for initializing crystal growth. A crystallization process normally is started due to evaporation of a liquid. Thus the device is adapted for evaporation of solvent in the area of the orifice. The loss of solvent is compensated by the directed capillary effect transporting liquid towards the orifice. Due to evaporation the remains of a solute form a growing crystal structure. The structure grown can be mono-crystalline or polycrystalline.

In an embodiment of the invention, the device comprises a body with a first side and a second side. A hollow space is formed within the body having at least a first orifice on the first side. The hollow space is adapted for receiving a liquid. Furthermore an area of the first orifice is smaller than an area of the second orifice. Alternately a cross-section or an area of a cross-section is decreasing towards the first orifice.

In another embodiment, the hollow space is adapted for creating different liquid shapes along the liquid-air interface of a droplet filled in the hollow space. A different liquid surface, for example created by different areas of the vessel can generate a directed capillary effect. The directed capillary effect will force the liquid towards the smaller area of the hollow space and thus towards the first orifice or aperture respectively. The driving force of the directed capillary effect is becoming zero as soon as the first liquid surface reaches the edge of the orifice or the surface of the body.

In an aspect of the device for crystal growth, the evaporation process of the solvent occurs at the liquid surface at all time, but starts significantly after one face of the liquid reaches the surface of the body. The process results in a crystal growth beginning at the surface in a very well defined area. This area will be within the orifice or the aperture of the vessel in the body. In an embodiment, the crystal is grown self-supporting, connected only along an edge of the aperture. This growth will allow access from two sides to the crystal and also improve different analysis and further processing techniques.

In yet another embodiment of the invention, the hollow space is formed at least partly as a truncated cone. Such truncated cone automatically generates a directed capillary effect towards the smaller basis. The direction of the directed capillary effect is depending on the wall geometry as well as structure and wall material. In an embodiment of the invention, the wall of the hollow space comprises at least partly a coated layer wetting-hostile to a liquid or to a solute filled in the vessel or hollow space respectively. Alternately the wall might comprise a coated layer wetting-friendly towards the liquid or the solute. In such embodiments of the invention the coated layer is adapted being lyophobic, hydrophobic or lyophilic and hydrophilic.

The wetting behavior also generates a capillary effect directed towards the parts with greater liquid-friendly behavior. The directed capillary effect can be generated by geometry of the vessel, or structures and material on the vessel's walls.

In another embodiment of the invention, the vessel at least partly comprises a coated layer. The coated layer is adapted for being attractive to at least one content of a solute of the liquid filled in the vessel. Such layers can be used for example to restrain some contents of the liquid from any crystallization process. For example, the liquid might be purified of not wanted molecules, which are attracted towards the coated layer. Alternately the coated layer is adopted for being repellent to at least one content of a solute. In a further embodiment the coated layer might comprise a gradual repellent or attractive behavior.

Specifically in an embodiment the invention, the wall of a truncated cone comprises at least partly a coated layer liquid-friendly or liquid-hostile to a solute filled in the truncated cone resulting in a directed capillary effect towards the smaller radius of the truncated cone.

Thus in the directed capillary effect can be controlled by the coating layer on the hollow space's walls. The coating can also be used in a tube, thereby generating a gradual capillary effect towards a specified direction, depending on the lyophobic or lyophilic behavior. In yet another embodiment of the invention, the hollow space comprises a cylindrical hollow space connected to a truncated conical hollow space. A basis of the conical hollow space is adapted of forming the orifice on the first side. In another embodiment of such invention, at least a part of the walls of such hollow space is coated with a wetting-friendly or wetting-hostile layer. For example the tube may be coated with a liquid-friendly layer to increase the directed capillary effect.

In a further embodiment of the invention, a cross-section of the hollow space is continuously decreasing towards the first orifice on the first side. A decreasing cross-section can generate a directed capillary effect almost independently of the hollow space's form.

In yet a further embodiment of the invention, the wall of the hollow space comprises a microstructure in the area of the first orifice. The microstructured area next to the first orifice improves the crystal growth at those areas as soon as evaporation of the solvent starts significantly.

In a further embodiment of the invention, the hollow space comprises a second orifice. The second orifice might be closed in yet another embodiment by a cover or a plate respectively. In a further embodiment, the cover comprises a foil, the foil comprising at least one of the following materials: stainless steel, gold, palladium or titanium. Plastics like PP, PEEK, or the like and polyimide or fluorpolymers are usable as well. Another material is DLC. In yet another embodiment of the invention, the cover might comprise a semi-permeable membrane.

The cover reduces or even prevents evaporation through the second orifice of the vessel. It will also prevent crystal growth on the walls of the vessel or hollow space between the second orifice and the surface of the liquid. In an embodiment of the invention, the cover comprises a lyophobic or wetting-hostile coating layer.

In an embodiment of the invention, the cover layer is adapted for reducing significantly any evaporation of the liquid filled in the hollow space, while maintaining pressure compensation at the same time. In another embodiment of the invention, the cover comprises a small orifice. The area of such orifice is much smaller than the area of the first orifice. The small orifice will compensate additional vapor pressure during filling a liquid into the hollow space. Still any significant evaporation of the liquid is prevented due to its small size.

Yet another embodiment, the first orifice comprises a structured collar thereby increasing the edge of the orifice. The increase of the edge will initialize a preferred crystal growth on that edge. In another embodiment the surface of the first side of the body near the first orifice is structured with grooves.

In a further embodiment the vessel comprises a second aperture on one side of a body. The second aperture is adopted for being connected to a removable supply chamber formed within a second body. Providing an additional supply chamber increases the flexibility in pre-processing and extends the volume available for crystal growth. The carrier comprising the grown crystal structure can be disconnected from the supply chamber and processed further. In an embodiment the supply chamber comprises an inlet area, the area being adapted for receiving a liquid.

For a well-defined crystal growth a vessel for a solvent is provided, the vessel is adapted for generating a directed capillary effect. Then the solvent is filled in the vessel. The directed capillary effect is forcing the solvent towards the first orifice of the vessel. There the solvent starts to evaporate significantly, thereby generating a crystal growth on the surface near the first orifice and especially along the meniscus of the liquid build at the first aperture. In an aspect, a self-supporting crystal is grown. In another aspect, a supply vessel is provided and connected to a second aperture of the vessel. Then a crystal is grown and the supply vessel is disconnected.

Embodiments might comprise one or more of the following features. The at least first orifice can be connected to a surface on at least a first side of the body. The hollow space can be adapted for receiving the liquid. The hollow space might comprise a second orifice, wherein an area of the first orifice is smaller than the area of the second orifice. At least one of a cross section and an area of a cross section of the hollow space can be continuously decreasing towards the first orifice. The hollow space can be formed at least partly as a truncated cone, and preferably a cone angle of the truncated cone lies between 3° and 120° and preferably between 10° and 90°. The hollow space may comprise a cylindrical hollow space connected to a truncated conical hollow space, a basis of the conical hollow space forming the orifice on the first side. The wall of the hollow space might comprise microstructure in the area of the first orifice.

Other embodiments, wherein a wall within the body forming the hollow space at least partly comprises a coated layer, might comprise one or more of the following features. The layer can be adapted for being wetting-hostile to a solvent filled in the hollow space. The layer can be adapted for being wetting-attractive to a solvent filled in the hollow space. The layer can comprise a gradient wetting-hostile to wetting-friendly behavior. The layer may be adapted for being attractive to at least one content of a solute of a liquid filled in the hollow space. The layer can be adapted for being repellant to at least one content of a solute of a liquid filled in the hollow space.

In one embodiment, the hollow space comprises a second orifice, an area of the first orifice is smaller than the area of the second orifice, and the second orifice is closed by a cover. The cover may comprise a foil, the foil comprising at least one of the following materials: stainless steel, titanium, palladium, gold, polypropylene, polyetherethercetone, polyimide, fluorpolymers, and diamond like carbon. The cover may comprise a wetting-hostile layer. The cover might comprise a small orifice, the area of the small orifice smaller than the area of the first orifice. The cover can comprise a semi-permeable membrane. The cover might be adapted for preventing evaporation of a liquid filled in the hollow space, while compensating a significant pressure difference between two sides of the cover.

Other embodiments might comprise one or more of the following features. The first orifice can be adapted for controlled evaporation of a liquid filled in the hollow space. The first orifice might comprise a structured collar thereby increasing an edge length of the first orifice. The surface of the first side of the body near the orifice can be structured with grooves or elevations, thereby increasing the surface area near the first orifice, wherein preferably the grooves or elevations are formed radial towards the first orifice. The body might comprise at least one of the following materials: stainless steel, titanium, polypropylene, polyphenylensulfide polyetherethercetone, polyimide, ceramics, fused silica or glass.

In one embodiment, the body comprises a second hollow space connected to the first orifice of the first hollow space and being adapted as a reaction chamber. The body might comprise at least a third hollow space, said at least third hollow space comprising an orifice connected to the second hollow space and further being adapted for receiving a liquid and generating a directed capillary effect towards the orifice. A wall within the body forming the second hollow space at least partly might comprise a coated layer, the layer adapted for being wetting-hostile or wetting-friendly to a liquid filled in first and/or third hollow space.

In one embodiment, the body comprises a second hollow space, the second hollow space being adopted for generating a directed capillary effect toward an area within the body, the area also being connected to the hollow space. The body can comprise at least a fourth hollow space, said at least fourth hollow space connected to the area and being adapted for receiving a liquid, wherein preferably the fourth hollow space comprises a diameter smaller than a diameter of the area.

Other embodiments might comprise one or more of the following features. A liquid droplet can be filled into a hollow space, the droplet comprising a first and a second surface connected to a gaseous phase, wherein the first and the second surface comprise a different curvature, resulting in a directed capillary effect. A liquid droplet might be filled in the hollow space, the droplet being so small, that the weight of the droplet is small compared to any force generating the directed capillary effect. The body might comprise a wall, said wall comprising an at least partly wetting-friendly or wetting-hostile coated layer.

In one embodiment, the body comprises a second orifice, the second orifice being connected to a removable liquid supply vessel. The liquid supply vessel might be arranged in a second body. The liquid supply vessel might comprise an inlet area, the inlet area being adapted for receiving the liquid.

Other embodiments might comprise one or more of the following features. The surface can be adapted for generating an adhesion force, thereby sucking liquid out of the orifice. The orifice might be adapted for generating a controlled evaporation process of a liquid being filled in the body. The orifice may be adapted for crystal growth within the orifice. A plurality of orifices and bodies can be connected thereto, said orifices being arranged on a plate surface.

A method for supporting crystal growth on a surface comprises providing a vessel for a liquid, the vessel comprising the surface and an aperture and being adapted for generating a directed capillary effect; filling the liquid into the vessel; and transporting the liquid towards the aperture of the first vessel due to the capillary effect, thereby supplying the surface with a liquid.

Other embodiments might comprise one or more of the following steps: evaporating the solvent, thereby generating crystal growth of a solute on a surface near the orifice; growing a self-supporting crystal structure of a solute on a surface of the liquid, the crystal connected only to the edge of the aperture; providing the vessel comprises providing a vessel with an at least partly conical shape, the conical shape generating a directed capillary effect towards the smaller basis of the conical shape; providing the vessel comprises providing a vessel with a first and a second aperture, at least one of the first and second apertures further being adapted for receiving the liquid; providing the vessel comprises providing a first vessel comprising an outlet area and being adapted for receiving a liquid, and providing a second vessel with an inlet area, the area being adapted for being connected to the outlet area of the second vessel, comprising the aperture and being adapted for generating a directed capillary effect.

In other embodiments filling the liquid might comprise one or more of the following steps: connecting one of the first and second apertures of the vessel to the surrounding area for pressure compensation, filling the liquid into the vessel through the first and/or the second aperture, and closing the one aperture; dropping the liquid onto the carrier surface near the aperture, the liquid at least partly connected to an edge of the carrier surface; filling a first liquid into the vessel, allowing a small volume of a gas into the vessel, and filling a second liquid into the vessel, the second liquid being separated form the first liquid by the gas volume.

Other embodiments might comprise one or more of the following steps: generating a vapor pressure between a bottom of the vessel and the liquid, thereby reducing crystal growth within the vessel; providing an activation seed for crystal growth on the first orifice. The method can be used for preparation a crystal for a matrix assisted desorption process.

### BRIEF DESCRIPTION OF DRAWINGS

While other objects and many of the intended advantages of embodiments of the present invention will be readily appreciated and become better understood by reference to the following description, the preferred embodiments in connection with the accompanied drawings are used therein for illustration purposes only. They do not limit the scope of protection. Features that are substantially or functionally equal or similar will be referred to with a same reference science.

Figure 1A shows a side view of a first embodiment of the invention.

Figure 1B shows a side view of the first embodiment with a grown crystal structure.

Figure 2 shows a side view of a second embodiment of the invention.

Figure 3 shows a side view of a third embodiment of the invention.

Figure 4 shows different top views of the first, second and third embodiment of the invention.

Figure 5 shows a more detailed view of the first embodiment of the invention.

Figure 6 shows a side view of a first embodiment of a microlab component according to one aspect of the invention.

Figure 7 shows a side view of fourth embodiment of the invention.

Figure 8 shows a side view of a fifth embodiment of the invention.

Figure 9 shows a detailed side- and top view of a growing crystal structure located within the orifice of sixth embodiment.

Figure 10 shows a detailed side- and top view of a grown crystal structure according to a seventh embodiment of the present invention.

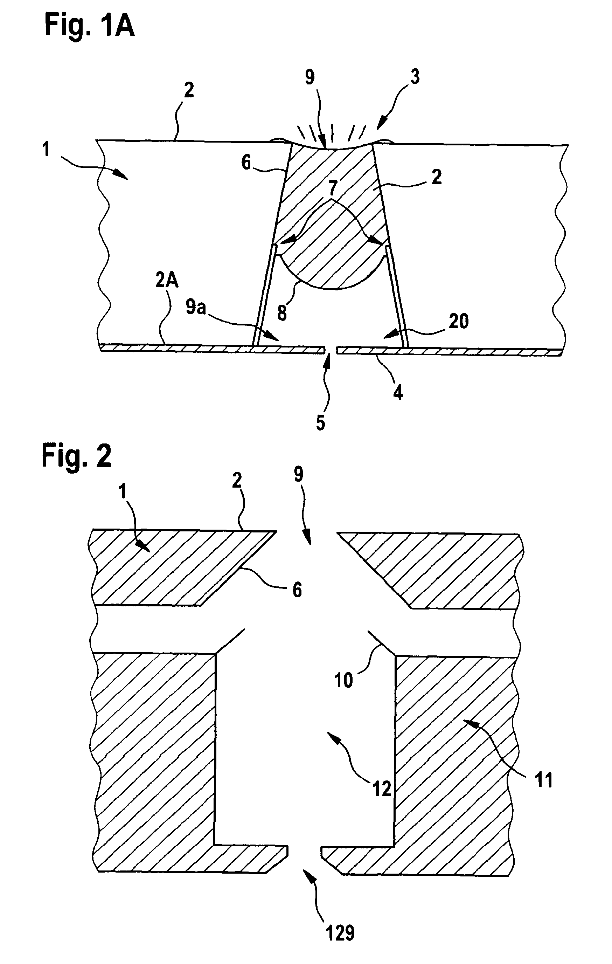

Figure 1A shows a first embodiment of a device for transporting liquid and for crystal growth. The device is also referred to as hollow anchor chip. The hollow anchor chip provides a well-defined area 9 for a crystal growth process out of a liquid L filled within a hollow space 20 of a body 1. The hollow space 20 is adapted for being a vessel. The vessel for a liquid and hollow space in a body for a liquid are referred to as the same feature hereafter. The area 9 comprises an orifice or an aperture, connecting the hollow space 20 to the surface 2 of body 1. The surface 2 next to the aperture comprises a microstructure and specifically comprises grooves 3 arranged radial around the orifice 9. Elevations can also be used instead of grooves.

The orifice or aperture 9 might comprise a circle with an area of some mm². Specifically the area of the aperture is in the range of 0.005 mm² to 5 mm². To increase the edge of the orifice it may be structured. Crystallization process normally starts at the edges of the orifice. In this example the hollow space 20 is filled with a liquid L. The liquid L comprises a first surface near the orifice 9. An adhesion force between the liquid attractive wall 6 of the hollow space and the liquid L is directed upwards and results in a curvature of the liquid's surface.

The body 1 comprises a material, which is inert for the chemical components of the liquid L. For example the body 1 comprises plastics like polypropylene (PP), polyphenylensulfide (PPS), polyetherethercetone (PEEK) or polyethylene (PE). Other materials for examples metals, glass or ceramics might also be used. Within the body 1 a hollow shape 20 is arranged. The hollow shape is adapted to form a truncated cone and comprises two orifices 9 and 9a on opposite sides of the body 1. The first base of a truncated cone on the first side 2 comprises a smaller area as the second basis on the second side 2a. The sidewall 6 in the upper part of the truncated cone comprises a wetting-friendly coated layer to the liquid L. In other word the wall comprises an attractive layer to the liquid. This attraction results in an adhesion force between the wall and the liquid.

In addition the truncated cone also comprises a second coated layer 7 arranged on the sidewall of the truncated cone in the lower part. The second coated layer 7 is adapted for being lyophobic and therefore wetting-hostile to the liquid L. The resulting cohesion force repels the liquid, forming an at least partly curved liquid surface. In other words when connecting the liquid L to the sidewall, the liquid is repelled in the area of the coated layer 7 and attracted in the area 6 of the sidewall. Thus as one can see, the surface of the liquid droplet L comprises curvatures in the same directions. The surface connected to the liquid repellent coating layer 7 is arched outwards, while the surface near the orifice 9 is arching itself inwards. The curvature of both liquids' surfaces is depending on the radius of the surface and the vessel 20. Due to the liquid curvature, a force directed to the center of the liquid curvature is generated.

A layer 4 is placed on the second side of the body 1, thereby closing the second orifice of the truncated cone. The membrane 4 also comprises a wetting hostile coated layer on its inner surface. Furthermore it comprises a very small orifice 5. This orifice 5 will allow small amounts of air flowing into the area 20 thereby compensating the pressure difference between the empty area of the hollow space 20 and the outside. However the orifice 5 is too small to support significant evaporation from the surface 8 of the liquid droplet L. Instead of a small orifice a semi-permeable membrane can be used as well.

Due to evaporation the area 20 is filled with a vapor pressure and equilibrium results between the vapor pressure in the area 20 and the liquid droplet L. The vapor pressure within the area remains constant over time, and almost no solvent can evaporate through the small orifice. Crystal growth on the sidewalls and specifically on the coated layer 7 is thereby minimized. Solvent is evaporated mainly from the liquid's surface near the orifice 9. Solute crystals start to grow on the edge of the orifice 9. The loss of solvent normally lowers the surface of the liquid droplet L. However due to the directed capillary effect any liquid L filled into the truncated cone is transported upwards in direction to the orifice 9 with its smaller radius. The effect is increased by the liquid hostile layer 7. The force of the directed capillary effect is decreasing over time but remains in the same direction until all solvent is evaporated. Evaporation and therefore crystal growth also continues until all solvent is evaporated. During crystal growth, small crystals are swimming on the surface of the liquid within the aperture. These small crystals are used as seeds for further crystallization.

The continuous evaporation process of solvent further increases solute concentration in the remaining liquid. The crystals on the surface of the liquid are growing and start to connect to the edge of the aperture. Since not all liquid is evaporated by now, the directed capillary effect forces the liquid towards the aperture, thereby supporting the crystals structure building on its surface. In other words, the liquid's surface is used as a carrier during the crystal growth process. If all liquid is evaporated, the solute is now crystallized in a high concentration on the microstructures 3 and within the aperture as a self-supporting crystal.

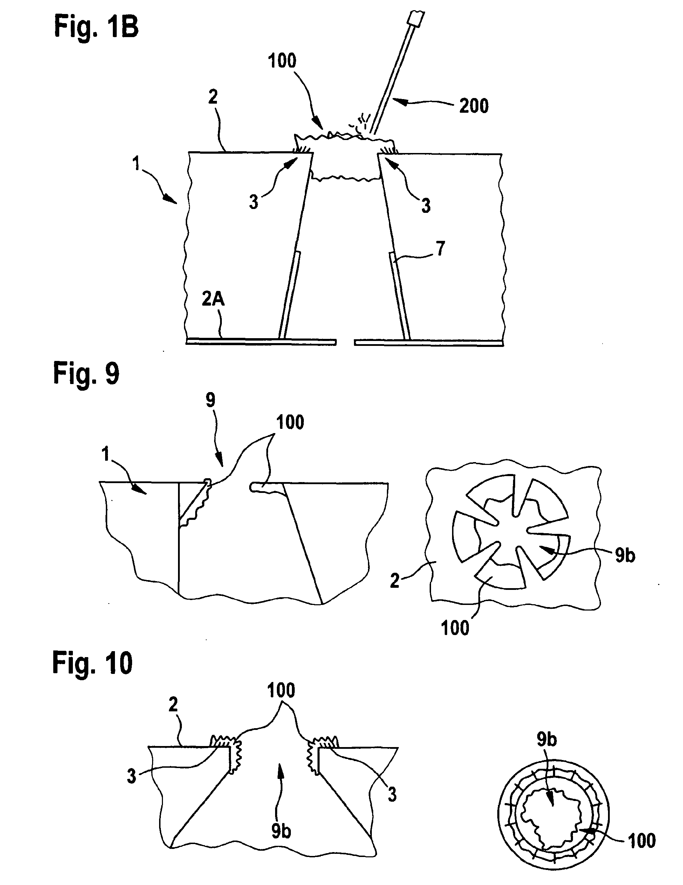

The resulting structure after all liquid is evaporated can be seen in Figure 1B. On the surface at the area 3 and within the orifice 9 a crystal structure 100 is grown. The parts of the crystal within the orifice 9 are self-supporting and connected only to the edge along the aperture 9. The area of the crystal 100 is well defined and known. The crystal on the surface can now be processed as a MALDI target or the like. A laser beam 200 is directed onto the crystal 100, sputtering the matrix and the analyte from the crystal's surface. If the laser beam 200 is directed onto the surface of the crystal within the orifice, no carrier material or remains of the carrier's surface are in the target area and only the crystal 100 will be sputtered. Furthermore the crystal might be accessible from two opposite sides.

Since the evaporation surface compared to the droplet volume is relatively low, a slow crystal growing can be generated and modified by adding additional solvent. Another aspect of embodiments of the invention is given by the size of the aperture that basically controls the evaporation rate. Evaporation can also be controlled by temperature, vapor pressure or other parameters. The geometry of the hollow shape, for example the cone angle in Figure 1A controls the speed of liquid transportation.

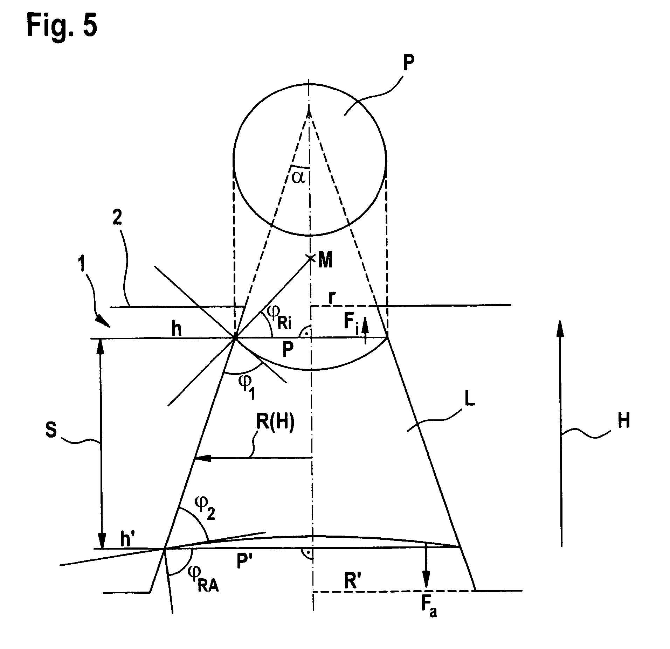

A more detailed view of the directed capillary effect can be seen in Figure 5. It will give an overview but is not restricted to the example used in Figure 5. Figure 5 shows a body 1 with a truncated hollow shaped cone. The truncated cone comprises a height H and a first basis having a first radius r and a second basis having a second radius R', the first radius r smaller than the second one R'. In this example the wall of the cone is attractive to the liquid. A liquid L is being filled within the truncated cone. As one can see the radius R(H) is dependent on the height H of the cone, decreasing with increasing height H. One can define the projection of the curved surface on the plane P, given by the edge of the liquid with the sidewall. In the example according to Figure 5, the plane P and P' can be described as a circle comprising an area.

After filling the liquid L into the cone the adhesion force is curving the surface of the liquid near the contact of the liquid's surface with the wall of the cone. The curvature is depending on the adhesion force to the wall and the cohesion pressure of the liquid. The adhesion force exists for both, the upper and the lower surface. If a droplet of liquid is placed within a normal capillary, having a constant cross section and a constant wetting behavior, the capillary pressure is equal but opposite on both faces of the liquid. The resulting forces along the capillary axis, given by the capillary pressure, are compensated and the droplet will not move.

With wetting friendly behavior for the cone's sidewall, the attraction to the wall tries to wet the surface's wall with the liquid L. Hence the curvature of the liquid's surface near the contact of the liquid's surface with the cone's sidewall is arching inwards. In a greater distance of the sidewall the cohesion force of the liquid, acting as counterpoise, is trying to flatten the liquid's surface. In a tube capillary comprising a big radius, this results in a strong liquid curvature on the contact area between the capillary's sidewall and the liquid's surface and an almost planar surface in the remaining liquid's surface. However, if the radius of the capillary is decreasing, the area of the liquid curvature in relation to the projected surface P will increase.

Due the cone angle α, the area of the projection onto plane P of the upper surface of the liquid is much smaller than the projection onto plane P' of the lower liquid's surface. On the other hand, the relation of the liquid surface compared to the area of the projection P is much higher for the upper surface then for the lower surface. The stronger curvature for the upper surface leads to a bigger area relation when compared to the projection.

The capillary pressure is now trying to reduce the liquid's surface. Due to van de Waals and other forces on atomic level, the liquid tries to reduce its surface to a minimum. The easiest way is to reduce the curvature of the liquid's surface. This will result in a force Fi and Fa respectively. The upper surface is drawn by the force Fi upwards, the force Fa draws the lower surface downwards. However, due to the stronger curvature for the upper surface the relation between the liquid's surface and the projected area is bigger than for the lower surface. In otherwords the upper surface might reduce its surface energy more efficiently, since its curvature is stronger. The different relations for the upper and lower surface lead to different values for the force Fi and Fa. Both forces, which compensate each other in the case of a normal tube with constant diameter are now different, resulting in a force directed upwards. The droplet will be forced in the direction of the smaller radius of the truncated cone or the direction wherein the relation of the liquids area compared to the radial projection is increasing.

The directed capillary effect can be enhanced by the lyophobic area 7 as seen in Figure 1A. The lyophobic area generates a cohesion force also directed towards the orifice 9. On the surface 2 of the body 1 or near the orifice 9, the liquid starts to evaporate and crystal growth is initiated at the grooves 3. This crystal growth process automatically continues until all solvent of the liquid L is evaporated.

Figure 2 shows another embodiment of the invention. The device according to this embodiment can be used for analysis and comprises a carrier, on which crystal growth and further processing takes place. A removable supply chamber can be connected to the carrier in order to supply solvent and solute for the crystal process.

The carrier comprises a truncated cone formed in the body 1 with its sidewall 6. The cone comprises an angle of roughly 90°. On the surface 2 of the carrier plate 1 small elevations are arranged around the aperture. Furthermore those elevation comprise a layer attractive to a solute's content of the solvent. The cone comprises a lower basis with a second orifice. This basis is adapted for being connected to a pre-processing unit 11, which is used as a supply chamber for solvent or solute.

The pre-processing unit 11 comprises a connector 10 adopted for a tight connection with the truncated cone of the carrier 1. It further comprises a pre-processing and supply area 12. The sidewall of the supply area includes a coated layer, which comprises a gradual wetting behavior. The behavior supports a directed capillary effect towards the connector 10 and the truncated cone in the carrier plate 1. A further inlet area 129 is connected to the chamber 12. In this embodiment of the invention the solvent can be mixed with the solute in the pre-processing area 12. It is also possible to fill the chamber through the inlet area 129.

For example the chamber 12 is connected to the carrier 1. Then a solute is filled up through the inlet area 129. Any further pre-processing is performed. Then the chamber is filled up with solvent through the area 129 until the solvent reaches the connector 10. Then the directed capillary effect forces the solvent towards the aperture 9. Due to evaporation a crystal structure is growing between the edge of the aperture 9. Solute is also concentrated on the surface due to the attraction.

The form of the cone as well as the orifice is flexible. The pre-processing device 11 can be disconnected after the crystallization process has been terminated. This embodiment is useful for MALDI environments wherein the pre-processing and the final analysis occur on different places. Also different solvents can be filled into the chamber, and even additional chemical reaction can be performed.

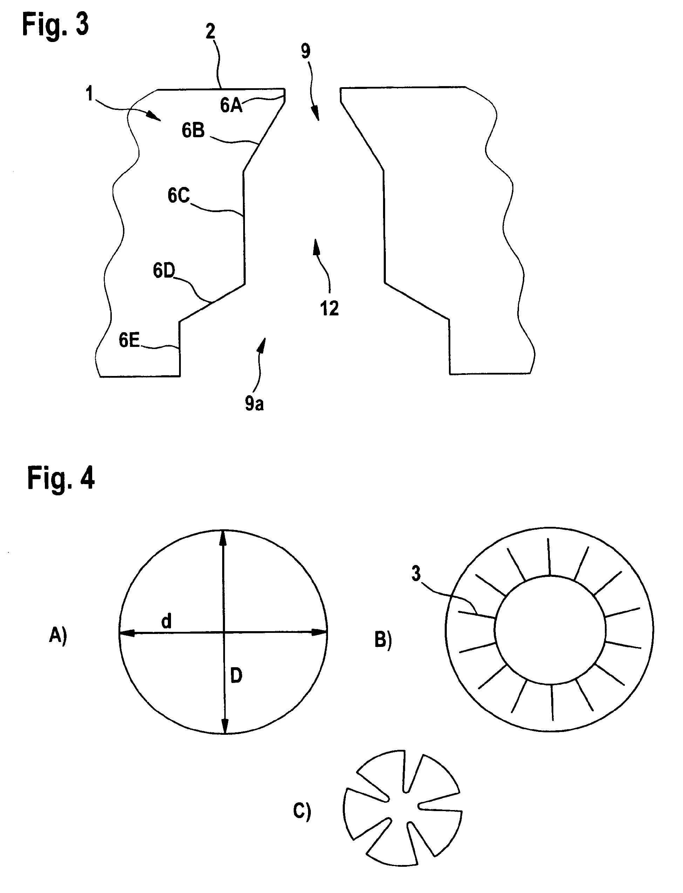

A further embodiment of the invention is shown in Figure 3. The body according to this embodiment comprises truncated cones with different sizes and angles as well as hollow cylinders connected together. A first area with the sidewall 6A is adapted as a crystallization area with an aperture to a surface. In this area 6A the walls are microstructured to initialize the crystal growth process when the evaporation of the solvent starts. The next area with the sidewalls 6B is formed as a first truncated cone with a directed capillary effect towards the crystallization area. The cylindrical hollow shape with the sidewall 6C is adapted of being a supply or process chamber. The remaining parts 6E and 6D are used for pre-processing or connection to an additional processing chamber. The two orifices 9 and 9a can be closed by membrane layers. The membrane layer prevents major vapor evaporation of the solvent, but allow small amounts of air into the hollow space. Thus pressure differences can be compensated. When the evaporation process is to be initialized the membrane layer of the first orifice 9 is simply removed.

The device according to Figure 3 can be filled partly with a first solvent form aperture 9. This is done by placing a droplet at least partly or preferably directly onto the aperture 9. When the liquid's surface is in contact with the edge of aperture 9, the adhesion force will draw the liquid into the vessel 12. This method automatically defines a specific area for the liquid. The process of sucking liquid into the vessel continues until all liquid is within the vessel. The speed can be controlled by the aperture 9a of the other side. Closing the aperture 9a stops the process. Using this method a solute can be places first onto the top surface 2. The solute is sucked into the vessel. Then a solvent comprising a matrix is placed on the surface and also sucked in. Solute and matrix are mixed and the solvent is evaporated through the aperture 9, leaving a matrix crystal including the specimen or analyte behind. It is also possible to separate a first and a second liquid within the vessel by a small amount of gas. This can be done by filling the vessel partly through aperture 9a, and then waiting a short amount of time, while the liquid is forced towards the aperture 9. Then the next solvent is filled into the vessel.

A top view of different apertures for the crystallization process can be seen in Figure 4. Figure 4A shows a simple aperture with oval structure having two diameters d and D. Other aperture structure like circles or even polygonal are possible. Figure 4B shows some grooves or elevations 3 on the surface arranged radial around the aperture. They are used to improve the transport of liquid onto the surface and accelerate the evaporation process of the solvent. For example solvent can flow along the grooves and then evaporate. The orifice according to a third embodiment in Figure 4C is structured to increase the length of the edge of the orifice. Increasing the length by structuring, the aperture will improve the crystallization process on the edges of the orifice.

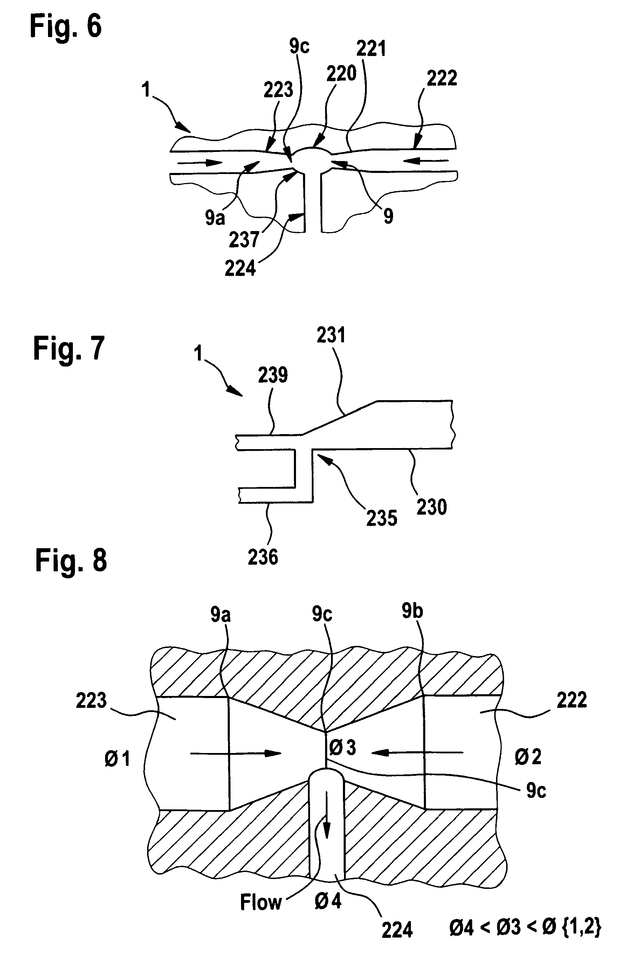

A further aspect of embodiments of the invention is found in Figure 6. The devices are used to transport two liquids to a mixing or reaction chamber. In a body 1, a mixing chamber 220 or a component of a microlab 220 is arranged. The body 1 is made of glass for example, although other materials can be used as well. The microlab 220 comprises a small volume and is adopted for mixing evaporated analytes. Furthermore the body 1 comprises three capillaries 223, 222, 224, which are connected through apertures with the component of the microlab 220. The capillary 222 as well as the capillary 223 comprises a first tube, connected to a truncated cone. The smaller basis of the truncated cone of capillaries 222 and 223 are adapted to form the apertures 9 and 9a respectively. They are connected to the mixing or reaction chamber 220. A third tube 224 is also connected to a third aperture. Two liquids with reactants are filled into capillaries 222 and 223. The capillary effect forces the liquid towards the apertures 9 and 9a. Here they start to evaporate, thereby mixing or reacting with each other in gaseous form in the mixing chamber 220. The resulted substances are forced along the tube 224.

A side view of an alternate embodiment of the invention can be seen in Figure 7. The capillary 230 is adapted for generating a directed capillary effect towards the aperture 235, which is connected to a first capillary 236 and a second capillary 239. As one can see, the geometry of capillary 230 is different, decreasing the cross section only on one side 231.

Another example can be seen in Figure 8. Here a first liquid filled in capillary 223 is directed due to the capillary effect towards the mixing area 9c. There it will stop, not flowing along the tube 224. The flow direction is rightwards. As soon as the second liquid filled in the second capillary 221 and forced to the same area 9c due to the directed capillary effect, the two liquids will be mixed. They are forced through the smaller orifice of tube 224. As one can see the diameter of the tube's 224 orifice is smaller than the mixing area 9c, which in turn is smaller than the diameters of the capillaries 223 and 222.

A further embodiment is shown in Figure 9. The hollow space is formed with a body 1, having an orifice 9 with an increased edge length. The top view on the right side shows a growing crystal structure 100. In this example, the crystal 100 is growing only within the orifice 9 on the sidewall of the hollow space. Crystallization seeds can be controlled by the edge characteristics of the orifice 9.

A further example with a different orifice is seen in Figure 10. The area 3 around the orifice is microstructured to force the crystallization onto the surface 2. Here an opening in the crystal structure 100 remains. The crystal is mainly formed in the area 3. An aperture 9b remains after the crystal 100 is grown completely.

These various embodiments can be used simultaneously, for example in an automatic processing and analysis tooling. Injecting liquid into a pre-processing chamber or the evaporation process is then controlled by software running on the analysis system. A plurality of such transporting and crystal growth devices can be arranged on a well plate or similar structures. The crystallization area is well defined, since mixing of solvent and specimen is now performed inside the vessel and not on the surface, on which in a later stage the evaporation process occurs. Mixing behavior becomes better and the crystal structure is improved.

## Claims

1. A system for matrix-assisted laser desorption/ionization mass spectrometry - MALDI-MS - comprising:
a device for transporting liquid and supporting crystal growth and representing a MALDI target, wherein the device comprises a hollow space (20) in a body (1) having a surface (2), the hollow space (20) has a first orifice (9) connected to the surface (2) and is adapted for generating a directed capillary effect towards the first orifice (9) in order to transport liquid to the first orifice (9) and to support crystal growth on the surface (2), and
a laser source adapted for providing a laser beam (200) onto the MALDI target.

2. The system of claim 1, wherein
at least one of a cross section and an area of a cross section of the hollow space (20) is continuously decreasing towards the first orifice (9).

3. The system of claim 1 or 2, wherein
the hollow space (20) is formed at least partly as a truncated cone.

4. The system of any of the above claims, wherein
the hollow space (20) comprises a cylindrical hollow space (6C) connected to a truncated conical hollow space (6B), a basis of the conical hollow space (6B) forming the orifice (9) on the first side.

5. The system of any of the above claims, wherein a wall within the body (1) forming the hollow space (20) at least partly comprises a coated layer (7).

6. The system of claim 5, wherein
the layer (7) is adapted for being wetting-hostile to a solvent filled (L) in the hollow space (20).

7. The system of claim 5, wherein
the layer (7) is adapted for being wetting-attractive to a solvent filled (L) in the hollow space (20).

8. The system of any one of the claims 5-7, wherein
the layer (7) comprises a gradient wetting-hostile to wetting-friendly behavior.

9. The system of any of the above claims, wherein
the first orifice (9) comprises a structured collar thereby increasing an edge length of the first orifice (9).

10. The system of any of the above claims, wherein
the surface (2) of the first side of the body (1) near the orifice (9) is structured with grooves (3) or elevations (3), thereby increasing the surface area near the first orifice.

11. The system of any of the above claims, wherein
the surface (2) is adapted for generating an adhesion force, thereby sucking liquid out of the orifice (9).

12. A method for providing a matrix-assisted laser desorption/ionization mass spectrometry - MALDI-MS - comprising:
growing a crystal structure on a surface (2) of a device, wherein the device comprises a hollow space (20) in a body (1), and the hollow space (20) has a first orifice (9) connected to the surface (2) and is adapted for generating a directed capillary effect towards the first orifice (9), the growing of the crystal structure comprising:
• transporting a liquid through the hollow space (20) to the first orifice (9) by means of the capillary effect, thereby supplying the surface (2) with the liquid, and
• evaporating the liquid, thereby generating crystal growth on the surface (2)
near the orifice (9); and
providing a laser beam (200) onto the surface (2) representing a MALDI target.

## Patentansprüche

1. System für die matrixgestützte Laserdesorptions-/lonisations-Massenspektrometrie (MALDI-MS), das aufweist:
eine Einheit zum Transportieren einer Flüssigkeit und zum Fördern des Kristallwachstums, die ein MALDI-Target darstellt, wobei die Einheit einen Hohlraum (20) in einem Körper (1) mit einer Oberfläche (2) aufweist und der Hohlraum (20) eine erste mit der Oberfläche (2) verbundene Öffnung (9) aufweist und zum Erzeugen einer zur ersten Öffnung (9) hin gerichteten Kapillarwirkung dient, um eine Flüssigkeit zur ersten Öffnung (9) hin zu transportieren und das Kristallwachstum auf der Oberfläche (2) zu fördern, und
eine Laserquelle zum Bereitstellen eines auf das MALDI-Target gerichteten Laserstrahls (200).

2. System nach Anspruch 1, wobei
ein Querschnitt und/oder eine Querschnittsfläche des Hohlraums (20) in Richtung zur ersten Öffnung (9) kontinuierlich abnimmt.

3. System nach Anspruch 1 oder 2, wobei
die Öffnung (20) zumindest teilweise die Form eines Kegelstumpfs aufweist.

4. System nach einem der vorhergehenden Ansprüche, wobei
der Hohlraum (20) einen mit einem kegelstumpfförmigen Hohlraum (6B) verbundenen zylindrischen Hohlraum (6C) aufweist, wobei eine Grundfläche des kegelförmigen Hohlraums (6B) die Öffnung (9) auf der ersten Seite bildet.

5. System nach einem der vorhergehenden Ansprüche, wobei eine Wand innerhalb des Körpers (1), welche den Hohlraum (20) bildet, zumindest teilweise eine Beschichtung (7) aufweist.

6. System nach Anspruch 5, wobei
die Schicht (7) durch ein in den Hohlraum (20) eingefülltes Lösemittel (L) nicht benetzbar ist.

7. System nach Anspruch 5, wobei
die Schicht (7) durch ein in den Hohlraum (20) eingefülltes Lösemittel (L) benetzbar ist.

8. System nach einem der Ansprüche 5 bis 7, wobei
die Schicht (7) einen Gradienten zwischen nicht benetzbarem und benetzbarem Verhalten aufweist.

9. System nach einem der vorhergehenden Ansprüche, wobei
die erste Öffnung (9) einen strukturierten runden Aufsatz aufweist und wodurch eine Kantenlänge der ersten Öffnung (9) vergrößert wird.

10. System nach einem der vorhergehenden Ansprüche, wobei
die Oberfläche (2) der ersten Seite des Körpers (1) nahe der Öffnung (9) durch Auskehlungen (3) oder Erhebungen (3) strukturiert ist und **dadurch** die Oberfläche nahe der ersten Öffnung vergrößert wird.

11. System nach einem der vorhergehenden Ansprüche, wobei
die Oberfläche (2) dazu dient, eine Adhäsionskraft zu erzeugen und **dadurch** eine Flüssigkeit aus der Öffnung (9) zu saugen.

12. Verfahren zum Bereitstellen einer matrixgestützten Laserdesorptions-/ lonisations-Massenspektrometrie (MALDI-MS), das folgende Schritte aufweist:
Aufwachsen einer Kristallstruktur auf eine Oberfläche (2) einer Einheit, wobei die Einheit einen Hohlraum (20) in einem Körper (1) aufweist, der Hohlraum (20) eine erste mit der Oberfläche (2) verbundene Öffnung (9) aufweist und zum Erzeugen einer zur ersten Öffnung (9) hin gerichteten Kapillarwirkung dient und das Aufwachsen der Kristallstruktur folgende Schritte aufweist:
• Transportieren einer Flüssigkeit durch die Kapillarwirkung durch den Hohlraum (20) zur ersten Öffnung (9) und **dadurch** Zuführen der Flüssigkeit zur Oberfläche (2), und
• Verdampfen der Flüssigkeit und **dadurch** Herbeiführen des
Kristallwachstums auf der Oberfläche (2) nahe der Öffnung (9), und
Bereitstellen eines auf die Oberfläche (2), welche das MALDI-Target darstellt, gerichteten Laserstrahls (200).

## Revendications

1. Système pour la spectrométrie de masse par désorption-ionisation laser assistée par matrice (MALDI-MS) comprenant :
un dispositif pour transporter un liquide et permettre la croissance de cristaux et représentant une cible MALDI, dans lequel le dispositif comprend un espace creux (20) dans un corps (1) comportant une surface (2), l'espace creux (20) comporte un premier orifice (9) relié à la surface (2) et est à même de générer un effet capillaire dirigé vers le premier orifice (9) afin de transporter le liquide vers le premier orifice (9) et de permettre la croissance de cristaux sur la surface (2), et
une source laser à même d'appliquer un faisceau laser (200) sur la cible MALDI.

2. Système suivant la revendication 1, dans lequel
une section transversale et/ou une zone d'une section transversale de l'espace creux (20) se réduisent de manière continue en direction du premier orifice (9).

3. Système suivant la revendication 1 ou 2, dans lequel
l'espace creux (20) se présente au moins en partie sous la forme d'un cône tronqué.

4. Système suivant l'une quelconque des revendications précédentes, dans lequel
l'espace creux (20) comprend un espace creux cylindrique (6C) relié à un espace creux conique tronqué (6B), une base de l'espace creux conique (6B) formant l'orifice (9) sur le premier côté.

5. Système suivant l'une quelconque des revendications précédentes, dans lequel
une paroi à l'intérieur du corps (1) formant l'espace creux (20) comprend au moins en partie une couche revêtue (7).

6. Système suivant la revendication 5, dans lequel
la couche (7) est à même d'être lyophobe à un solvant versé (L) dans l'espace creux (20).

7. Système suivant la revendication 5, dans lequel
la couche (7) est à même d'être lyophile à un solvant versé (L) dans l'espace creux (20).

8. Système suivant l'une quelconque des revendications 5 à 7, dans lequel la couche (7) présente un comportement lyophobe/lyophile à gradient.

9. Système suivant l'une quelconque des revendications précédentes, dans lequel
le premier orifice (9) comprend un col structuré, accroissant de ce fait une longueur de bord du premier orifice (9).

10. Système suivant l'une quelconque des revendications précédentes, dans lequel
la surface (2) du premier côté du corps (1) près de l'orifice (9) est structurée avec des gorges (3) ou des élévations (3), accroissant de ce fait la surface près du premier orifice.

11. Système suivant l'une quelconque des revendications précédentes, dans lequel
la surface (2) est à même de générer une force d'adhérence, aspirant de ce fait le liquide hors de l'orifice (9).

12. Procédé pour permettre une spectrométrie de masse par désorption-ionisation laser assistée par matrice (MALDI-MS) comprenant :
la croissance d'une structure cristalline sur une surface (2) d'un dispositif, dans lequel le dispositif comprend un espace creux (20) dans un corps (1), et l'espace creux (20) comporte un premier orifice (9) relié à la surface (2) et est à même de générer un effet capillaire dirigé vers le premier orifice (9), la croissance de la structure cristalline comprenant :
• le transport d'un liquide à travers l'espace creux (20) jusqu'au premier orifice (9) par l'effet capillaire, fournissant de ce fait le liquide à la surface (2), et
• l'évaporation du liquide, générant de ce fait la croissance de cristaux sur la surface (2) près de l'orifice (9), et
l'application d'un faisceau laser (200) sur la surface (2) représentant une cible MALDI.
